# EUROPEAN PATENT APPLICATION

(11) **EP 4 750 247 A1**
(43) Date of publication of application: **27.05.2026**
(21) Application number: 25175227.5
(22) Date of filing: 09.05.2025
(51) Int. Cl.: H10D 10/40, H10D 10/80, H10D 62/13, H10D 64/23, H10D 64/62, H10D 10/01

(54) **VERTICAL HETEROJUNCTION BIPOLAR TRANSISTORS WITH IMPROVED COLLECTOR CONTACTS**

(30) Priority: 26.11.2024 US 202418959786
(71) Applicant: GlobalFoundries U.S. Inc., Malta, NY 12020 (US)
(72) Inventor: Raghunathan, Uppili Srinivasan, Essex Junction, VT 05452 (US); Jain, Vibhor, Essex Junction, VT 05452 (US); Shank, Steven M., Essex Junction, VT 05452 (US); Vallett, Aaron Lee, Essex Junction, VT 05452 (US)
(74) Representative: Grünecker Patent- und Rechtsanwälte PartG mbB

(57) **Abstract**

The present disclosure relates to vertical heterojunction bipolar transistors (10) and methods of manufacturing. The structure includes: a sub-collector region (14); a collector region (12, 26) over the sub-collector region, the collector region having a first semiconductor material (12) comprising polysilicon material (12a) and single crystalline semiconductor material (12b) which is over the sub-collector region, and a second semiconductor material (26) on the single crystalline semiconductor material (12b); STI regions (16) under the polysilicon first semiconductor material (12a); diffusion regions (22) in the polysilicon first semiconductor material (12a); a base region (30) over the collector region (12, 26); and an emitter region (32) over the base region (30).

## Description

### BACKGROUND

The present disclosure relates to semiconductor structure and, more particularly, to heterojunction bipolar transistors and methods of manufacture.

A heterojunction bipolar transistor (HBT) is bipolar junction transistor (BJT) that uses different semiconductor materials for the emitter and base regions, creating a heterojunction. The HBT handles signals of very high frequencies, up to several hundred GHz. The HBT is commonly used in ultrafast circuits including, for example, radio frequency (RF) systems, and in applications requiring a high power efficiency, including RF power amplifiers in cellular telephones.

### SUMMARY

In an aspect of the disclosure, a structure comprises: a sub-collector region; a collector region over the sub-collector region, the collector region comprising a first semiconductor material comprising polysilicon material and single crystalline semiconductor material which is over the sub-collector region, and a second semiconductor material on the single crystalline semiconductor material; diffusion regions in the first semiconductor material; an emitter region over the collector region; and a base region adjacent to the emitter region.

In an aspect of the disclosure, a structure comprises: a sub-collector region; a dielectric material above the sub-collector region with an opening exposing the sub-collector region; a semiconductor material within the opening and adjacent to the dielectric material, the semiconductor material comprising polysilicon material adjacent to the dielectric material and single crystalline semiconductor material over the sub-collector region; a second semiconductor material over the single crystalline semiconductor material; an emitter region over the second semiconductor material; and a base region isolated from the emitter region and above the second semiconductor material.

In an aspect of the disclosure, a method comprises: forming a sub-collector region; forming a collector region over the sub-collector region, the collector region comprising a first semiconductor material comprising polysilicon material and single crystalline semiconductor material which is over the sub-collector region, and a second semiconductor material on the single crystalline semiconductor material; forming diffusion regions in the first semiconductor material; an emitter region over the collector region; and forming a base region adjacent to the emitter region.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIG. 2 shows a structure in accordance with additional aspects of the present disclosure.
FIGS. 3A-3D show fabrication steps for manufacturing the structure of FIG. 1 in accordance with aspects of the present disclosure.

### DETAILED DESCRIPTION

The present disclosure relates to semiconductor structures and, more particularly, to heterojunction bipolar transistors and methods of manufacture. More specifically, the heterojunction bipolar transistors may be high breakdown SiGe heterojunction bipolar transistors. In embodiments, the high breakdown SiGe heterojunction bipolar transistors comprise additional epitaxial semiconductor material between the collector region and sub-collector region. In this configuration, the additional epitaxial semiconductor material will provide a thicker collector region which, in turn, effectively provides separation between a base region and an abruptly implanted sub-collector region. In some embodiments, collector contacts may also be provided over shallow trench isolation structures to reduce area. Advantageously, the configuration described herein provides a significant area reduction, while achieving a high breakdown voltage and increased performance, e.g., reducing collector substrate capacitance (Ccs )and significantly improving fT/fmax.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

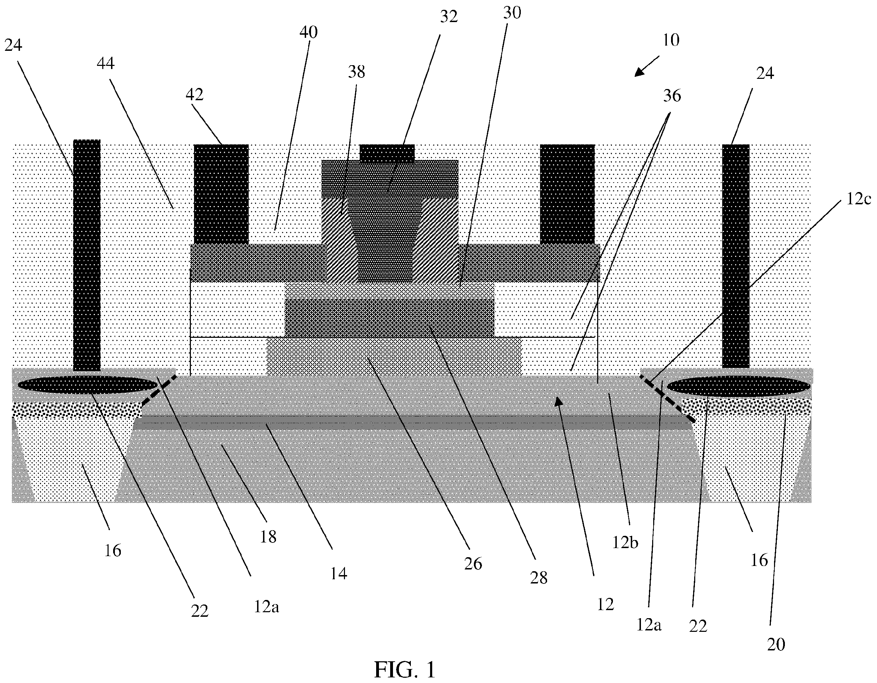

FIG. 1 shows a structure and respective fabrication processes in accordance with aspects of the present disclosure. In the structure 10 of FIG. 1, a semiconductor material 12 may be formed above a sub-collector region 14 and below a collector region (e.g., semiconductor material 26). The semiconductor layer 12 may extend over a shallow trench isolation region 16. The semiconductor layer 12 may be polysilicon 12a over the shallow trench isolation region 16, which transitions into a single crystalline semiconductor material 12b over the sub-collector region 14. The single crystalline semiconductor material 12b may act as a collector region with the semiconductor material of the collector region 16 to effectively increase the thickness of the collector region.

In more specific embodiments, the structure 10 includes a semiconductor substrate 18. In embodiments, the semiconductor substrate 18 may be a p-type semiconductor material. In more specific embodiments, the semiconductor substrate 18 may be a lightly p-doped single crystalline semiconductor material. The single crystalline semiconductor material may be Si material; although other semiconductor materials are also contemplated herein, e.g., SiGe, SiGeC, SiC, GaAs, InAs, InP, and other III/V or II/VI compound semiconductors.

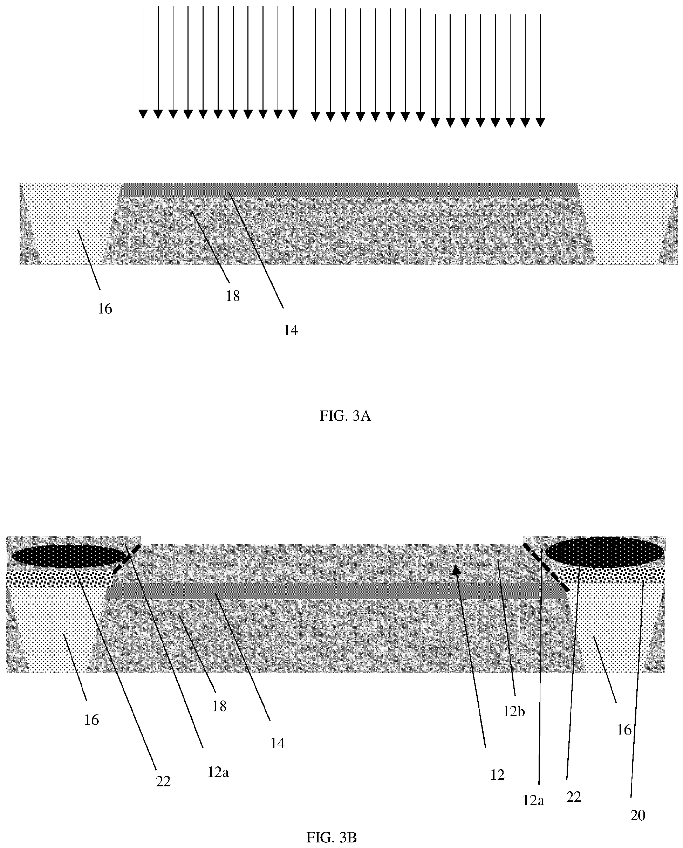

Still referring to FIG. 1, the sub-collector region 14 may be formed over the semiconductor substrate 18. In embodiments, the sub-collector region 14 may be formed by a conventional epitaxial growth process with an in-situ doping. The sub-collector region 14 may be single crystalline Si material; although other materials as described herein are also contemplated for use in the present disclosure. The sub-collector region 14 may be heavily doped with an n-type dopant, e.g., e.g., Arsenic (As), Phosphorus (P) and Antimony (Sb), among other suitable examples, as described with respect to FIG. 3A. In the configuration, a deep implant may be provided in the deep sub-collector region 14, e.g., about or over 1e18 cm-3, due to the thicker collector region (e.g., combination of the semiconductor material 12b and semiconductor material 26 form a thick collector region). It should be understood by those of skill in the art that the device can be an NPN or PNP by inverting the doping scheme described herein (e.g., inverting doping of the emitter, base, collector and sub-collector regions).

The shallow trench isolation structures 16 may be formed in the semiconductor substrate 18 and semiconductor material of the sub-collector region 14. The shallow trench isolation structures 16 can be formed by conventional lithography, etching and deposition methods known to those of skill in the art and as described with respect to FIG. 3A.

FIG. 1 further shows a gate dielectric material 20 formed over the shallow trench isolation structures 16. In embodiments, the gate dielectric material 20 may be a high-k or low-k dielectric material as is known in the art. For example, the gate dielectric material 20 may be an oxide based material. As another example, the gate dielectric material 20 may be a hafnium based material.

The gate dielectric material 20 may be deposited by a conventional deposition method, e.g., chemical vapor deposition (CVD), followed by a conventional patterning process, e.g., lithography and etching process, as already described herein, as further described with respect to FIG. 3B. The gate dielectric material 20 may include an opening in the collector region to connect a base material to the semiconductor material of the sub-collector region 14. In embodiments, the gate dielectric material 20 may also be used for the fabrication of a gate structure, where the opening of the gate dielectric material 20 may be wider than the gate structure.

The semiconductor material 12 may be formed over the gate dielectric material 20 and the exposed semiconductor material of the sub-collector region 14. In embodiments, the semiconductor material 12 may form part of the collector region of the structure with the overlying semiconductor material 26. The combination of the semiconductor material 12 and overlying semiconductor material 26 may form a thick collector region. The semiconductor material 12 and overlying semiconductor material 26 may preferably be Si or SiGe (with a low concentration of Ge); although other semiconductor materials formed by an epitaxial growth process are also contemplated as is known in the art. In embodiments, the overlying semiconductor material 26 may have a smaller profile than the sectional semiconductor material 12, e.g., the width of the overlying semiconductor material 26 may be smaller than the width of the semiconductor material 12. The semiconductor material 12 may be used to form gate structures, e.g., polysilicon electrodes of a gate structure.

Also, as should be understood by those of skill in the art, the semiconductor material 12 may form as polysilicon material 12a over the gate dielectric material 20 and the shallow trench isolation structures 16; whereas the semiconductor material 12 may form as single crystalline semiconductor material 12b over the sub-collector region 14. As to the single crystalline semiconductor material 12b, it should be understood that this material will have a full crystalline realignment over the single crystalline material of the sub-collector region 14, and may be used as a collector region. A transition region 12c may be provided between the polysilicon material 12a and the single crystalline semiconductor material 12b at an edge of the shallow trench isolation region 16.

In this configuration, the collector region is thickened by the combination of the single crystalline semiconductor material 12b and overlying semiconductor material 26, e.g., an Si layers, over the active region (e.g., semiconductor material of the sub-collector region 14). Due to the additional semiconductor material 12a, it is now possible to have a higher and deeper doping concentration in the sub-collector region 14 as further described in FIG. 3A. The higher-dose implant allows more vertical scaling and improved fT/fmax. In addition, a shallow high-dose implant can improve the sub-collector concentration by two orders of magnitude with no impact on collector-substrate breakdown voltage (BVcso) or Ccs.

FIG. 1 further shows diffusion regions 22 in the polysilicon material 12a. In embodiments, the diffusion regions 22 may be provided over the gate dielectric material 20 and the shallow trench isolation structures 16. The diffusion regions 22 may preferably be n-type dopant, e.g., Arsenic (As), Phosphorus (P) and Antimony (Sb), among other suitable examples, using conventional ion implantation processes as described with respect to FIG. 3B. In embodiments, the n-type doping is preferably N++.

Collector contacts 24 may connect (electrically contact and/or directly contact) to the diffusion regions 22 in the polysilicon material 12a and over the shallow trench isolation structures 16. The collector contacts 24 may be via interconnects as is known in the art. For example, the collector contacts 24 may be tungsten, aluminum, copper or other known conductive metals formed by conventional lithography, etching and deposition methods known in the art. The location of the collector contacts 24 over the shallow trench isolation structures 16 results in an area reduction in the active region, e.g., sub-collector region 14, while also improving Ccs.

The semiconductor material 26 may be provided over the semiconductor material 12b. In embodiments, the semiconductor material 26 may comprise the intrinsic collector region contacting the semiconductor material 12b over the active region, e.g., sub-collector region 14. The semiconductor material 26 may be the same material as the semiconductor material 12b, e.g., Si or SiGe, formed by an epitaxial growth process.

A base region 28 may be formed over the semiconductor material 26. In embodiments, the base region 28 may be an intrinsic base region composed of SiGe material, as an example. An intrinsic emitter region 30 may be formed over the base region 28, with an emitter region 32 formed on the intrinsic emitter region 30. In this way, the sub-collector region 14, the collector region, e.g., semiconductor materials 12b, 26, the base region 28 and the emitter regions 30, 32 are vertically stacked.

The intrinsic emitter region 30 and the emitter region 32 may be composed of Si material and, more specifically, polysilicon material. Insulator material 36 may be provided adjacent to the collector material 26, base region 28 and intrinsic emitter region 30. The insulator material 36 may be, for example, alternating layers of oxide and nitride or combinations thereof. In embodiments, two layers of insulator material 36 may be contemplated herein. In further embodiments, the insulator materials (e.g., dielectric layers) do not extend beyond the collector contacts 42.

The emitter region 32 includes sidewall spacers 38. In embodiments, the sidewall spacers 38 may be a nitride material. The sidewall spacers 38 may isolate the emitter region 32 from an extrinsic base region 40. The extrinsic base region 40 may connect to (e.g., electrically connect) the intrinsic base region 28. The extrinsic base region 40 may be, for example, SiGe. Contacts 42 may be provided to the emitter region 32 and the extrinsic base region 40. The contacts 42 may be via interconnects formed in interlevel dielectric material 44, similar to contacts 24 the contacts 42 and 24 may be formed in a same fabrication process, surrounded by the interlevel dielectric material 44. In embodiments, the interlevel dielectric material 44 may be different than the dielectric layers 36. For example, the interlevel dielectric material 44 may separate insulator materials 36 from the collector contact 24. Additionally, the extrinsic base layer 40 may directly sit on the insulator layers 36 associated with the epitaxial semiconductor material.

Prior to forming the contacts 24, 42, a silicide contact may be formed on the emitter region 32, the extrinsic base region 40 and the polysilicon material 12a. As should be understood by those of skill in the art, the silicide process begins with deposition of a thin transition metal layer, e.g., nickel, cobalt or titanium, over fully formed and patterned semiconductor material (e.g., emitter region 32, the extrinsic base region 40 and the polysilicon material 12a). After deposition of the material, the structure is heated allowing the transition metal to react with exposed silicon (or other semiconductor material as described herein) in the active regions of the semiconductor device (e.g., emitter region 32, the extrinsic base region 40 and the polysilicon material 12a) forming a low-resistance transition metal silicide. Following the reaction, any remaining transition metal is removed by chemical etching, leaving silicide contacts in the active regions of the device.

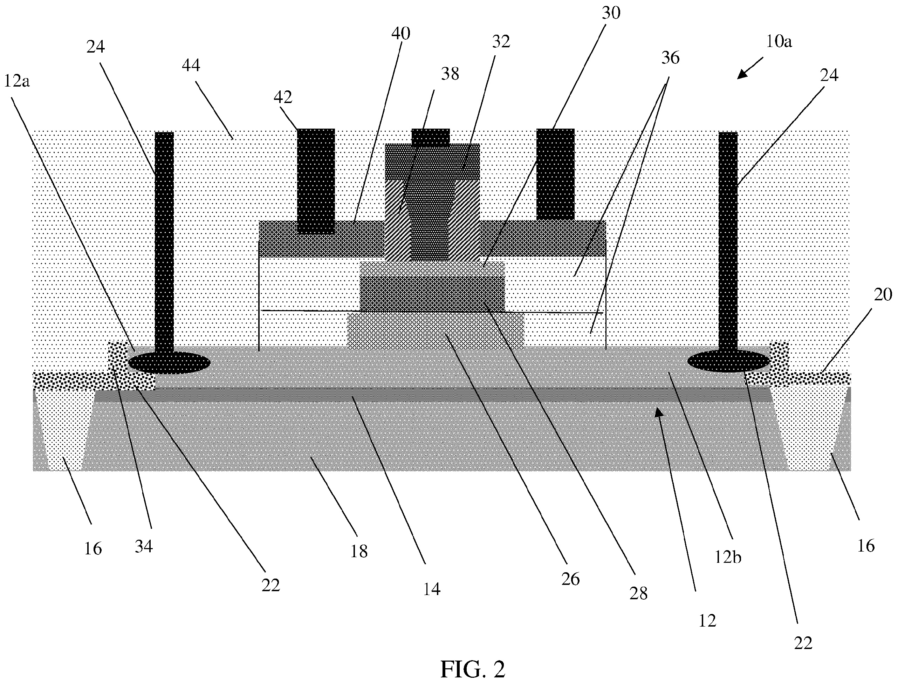

FIG. 2 shows a structure in accordance with additional aspects of the present disclosure. In the structure 10a of FIG. 2, the diffusion regions 22 and the respective contacts 24 may be formed adjacent to or slightly overlapping with the shallow trench isolation structures 16. The diffusion regions 22 may be formed in the semiconductor material 12 and, preferably, withing the polysilicon material 12a formed adjacent to the gate dielectric material 22. In this embodiment, a vertical insulator portion 34 may be above the gate dielectric material 22 and extend at an end or edge of the semiconductor material 12. The diffusion regions 22 may be formed adjacent to the vertical section, on an opposing side from the shallow trench isolation structures 16. The remaining portions of the structure 10a are similar to the structure 10 as described with respect to FIG.1 such that no further explanation is required for a complete understanding of the present disclosure.

FIGS. 3A-3D show fabrication steps for manufacturing the structure of FIG. 1 in accordance with aspects of the present disclosure. FIGS. 3A-3D may equally represent fabrication steps for manufacturing the structure of FIG. 2 by adjusting patterning processes to form the semiconductor material 12 adjacent to shallow trench isolation structures, as an example.

FIG. 3A shows the formation of the sub-collector region 14 over the semiconductor substrate 18. The semiconductor material of the sub-collector region 14 may be formed by a conventional epitaxial growth process. Examples of various epitaxial growth process apparatuses that can be employed in the present application include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature from 300° C. to 800° C. The epitaxial growth can be performed utilizing any well-known precursor gas or gas mixture. Carrier gases like hydrogen, nitrogen, helium and argon can be used. A dopant (n-type or p-type, as defined below) is typically added to the precursor gas or gas mixture.

The semiconductor material of the sub-collector region 14 may be subjected to a conventional ion implantation process that introduce a high concentration and/or dosage of n-type dopant in the semiconductor material of the sub-collector region 14. In embodiments, a patterned implantation mask may be used to define selected areas exposed for the implantation. The implantation mask may include a layer of a light-sensitive material, such as an organic photoresist, applied by a spin coating process, prebaked, exposed to light projected through a photomask, baked after exposure, and developed with a chemical developer. The implantation mask has a thickness and stopping power sufficient to block masked areas against receiving a dose of the implanted ions.

FIG. 3A further shows the formation of the shallow trench isolation structures 16. The shallow trench isolation structures 16 may be formed by conventional lithography, etching and deposition processes. For example, a resist formed over the semiconductor material of the sub-collector region 14 is exposed to energy (light) and developed utilizing a conventional resist developer to form a pattern (opening). An etching process with a selective chemistry, e.g., reactive ion etching (RIE), will be used to transfer the pattern of the photoresist to the semiconductor substrate 16 and the semiconductor material of the sub-collector region 14 to form one or more trenches in semiconductor substrate 18 and the semiconductor material of the sub-collector region 14. Following resist removal by a conventional oxygen ashing process or other known stripants, insulator material (e.g., SiOx) can be deposited by any conventional deposition processes, e.g., chemical vapor deposition (CVD) processes. Any residual material on the surface of the semiconductor material of the sub-collector region 14 can be removed by conventional chemical mechanical polishing (CMP) processes.

In FIG. 3B, gate dielectric material 20 may be formed over the semiconductor material of the sub-collector region 14. The gate dielectric material 20 may be formed by conventional deposition processes, e.g. CVD, followed by a patterning process, e.g., lithography and etching, to remove portions of the gate dielectric material 20 over the active regions of the device, e.g., semiconductor material of the sub-collector region 14. In this way, the semiconductor material of the sub-collector region 14 will be exposed for subsequent fabrication processes. Also, in embodiments, the gate dielectric material 20 will remain over the shallow trench isolation structures 16.

FIG. 3B further shows the semiconductor material 12 formed over the gate dielectric material 20 and the exposed semiconductor material of the sub-collector region 14. In embodiments, the semiconductor material 12 may also be formed over the shallow trench isolation structures 16. The semiconductor material 12 may be formed by conventional epitaxial growth process with polysilicon material 12a forming over the gate dielectric material 20 and the shallow trench isolation structures 16, and single crystalline semiconductor material 12b formed over the semiconductor material of the sub-collector region 14.

The diffusion regions 22 may be formed in the polysilicon material 12a over the gate dielectric material 20 and the shallow trench isolation structures 16. The diffusion regions 22 may be formed by conventional ion implantation processes.

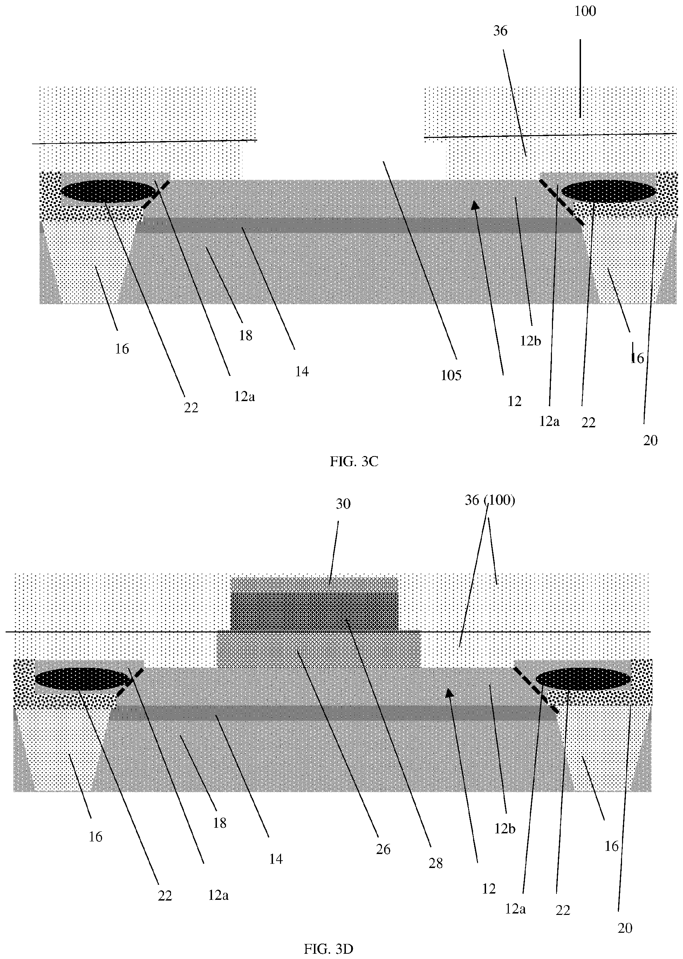

In FIG. 3C, a layer of insulator material 36 and a hard mask 100, e.g., nitride, may be formed over the semiconductor material 12. The insulator material 36 and the mask 100 may form the stack of dielectric material 36 as shown in FIG. 3D. The insulator material 36 and the mask 100 may be patterned using conventional lithography and etching processes as known in the art to form an opening 105. The opening may expose the underlying semiconductor material 12, e.g., single crystalline semiconductor material 12b.

In FIG. 3D, the semiconductor material 26, semiconductor material of the base region 28 and semiconductor material of the intrinsic emitter region 30 may be formed within the opening. For example, each of the semiconductor materials may be formed by separate epitaxial growth process as is known in the art. In embodiments, the semiconductor material 26 is formed directly over and in contact with the exposed semiconductor material 12b. The semiconductor material of the base region 28 may be formed directly over and in contact with the semiconductor material 26. Similarly, the semiconductor material of the intrinsic emitter region 30 may be formed directly over and in contact with the semiconductor material of the base region 28.

Referring back to FIG. 1, the semiconductor material of the extrinsic base region 40 may be formed over the insulator material 36 and hardmask 100 and the intrinsic emitter region 32. The extrinsic base region 40 will electrically connect to the intrinsic base region 28. An opening may be formed in the semiconductor material of the semiconductor material of the extrinsic base region 40 to expose the intrinsic emitter region 30. The opening may be formed using conventional lithography and etching process as is known in the art. The sidewall spacers 38 may be formed on sidewalls of the opening using a conventional deposition method followed by an anisotropic etching process as is known in the art. The semiconductor material of the emitter region 32 may be formed in the opening, contacting the underlying intrinsic emitter region 30 and covering the sidewall spacers 38. The semiconductor material of the emitter region 32 may be formed by an epitaxial growth process, forming polysilicon material due to contact with the sidewall spacers 38. The sidewall spacers 38 will isolate the emitter region 32 from the extrinsic base region 40. The contacts 24, 42 may be formed by conventional lithography, etching and deposition process in the interlevel dielectric material 44.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, the present disclosure relates to semiconductor structure and, more particularly, to heterojunction bipolar transistors and methods of manufacture. The structure includes: a sub-collector region; a collector region over the sub-collector region, the collector region having a first semiconductor material comprising polysilicon material and single crystalline semiconductor material which is over the sub-collector region, and a second semiconductor material on the single crystalline semiconductor material; diffusion regions in the first semiconductor material; an emitter region over the collector region; and a base region adjacent to the emitter region.

The following embodiments are explicitly disclosed:
Embodiment 1: A structure comprising:
a sub-collector region;
a collector region over the sub-collector region, the collector region comprising a first semiconductor material comprising polysilicon material and single crystalline semiconductor material which is over the sub-collector region, and a second semiconductor material on or over the single crystalline semiconductor material;
diffusion regions in the first semiconductor material;
an emitter region over the collector region; and
a base region adjacent to the emitter region.
Embodiment 2: The structure of embodiment 1, further comprising shallow trench isolation structures isolating the sub-collector region.
Embodiment 3: The structure of embodiment 2, further comprising collector contacts over the polysilicon material and adjacent to the shallow trench isolation structures.
Embodiment 4: The structure of embodiment 2 or 3, wherein the polysilicon material is over the shallow trench isolation structures and collector contacts extend to the polysilicon material over the shallow trench isolation structures.
Embodiment 5: The structure of embodiment 4, wherein the diffusion regions are over the shallow trench isolation structures in the polysilicon material and under the collector contacts.
Embodiment 6: The structure of embodiment 4 or 5, further comprising a dielectric material between the shallow trench isolation structures and the polysilicon material.
Embodiment 7: The structure of embodiment 6, wherein the dielectric material comprises oxide with an opening to expose the sub-collector region.
Embodiment 8: The structure of embodiment 6 or 7, wherein the dielectric material comprises a gate dielectric material that is adjacent to the single crystalline semiconductor material sitting over the sub-collector region.
Embodiment 9: The structure of one of embodiments 1 to 8, wherein the sub-collector region comprises N++ dopant.
Embodiment 10: The structure of embodiment 9, wherein the N++ dopant comprises a concentration of about or greater than 1e18 cm-3 or 1*10¹⁸ cm⁻³_{.}
Embodiment 11: The structure of one of embodiments 1 to 10, wherein the second semiconductor material of the collector region comprises single crystalline Si.
Embodiment 12: The structure of one of embodiments 1 to 11, wherein the sub-collector region, the collector region, the emitter region and the base region are vertically stacked.
Embodiment 13: The structure of one of embodiments 1 to 12, further comprising:
   a dielectric material above the sub-collector region with an opening exposing the sub-collector region;
   the first semiconductor material within the opening and adjacent to the dielectric material, the first semiconductor material comprising polysilicon material adjacent to the dielectric material and single crystalline semiconductor material over the sub-collector region;
   the second semiconductor material over the single crystalline semiconductor material;
   the emitter region over the second semiconductor material; and
   the base region isolated from the emitter region and above the second semiconductor material.
Embodiment 14: A structure comprising:
   a sub-collector region;
   a dielectric material above the sub-collector region with an opening exposing the sub-collector region;
   a first semiconductor material within the opening and adjacent to the dielectric material, the first semiconductor material comprising polysilicon material adjacent to the dielectric material and single crystalline semiconductor material over the sub-collector region;
   a second semiconductor material over the single crystalline semiconductor material;
   an emitter region over the second semiconductor material; and
   a base region isolated from the emitter region and above the second semiconductor material.
Embodiment 15: The structure of embodiment 13 or 14, further comprising shallow trench isolation structures below the dielectric material, and collector contacts above the shallow trench isolation structures and the dielectric material.
Embodiment 16: The structure of one of embodiments 13 to 15, wherein the first semiconductor material and the second semiconductor material comprise a collector region electrically connecting to the sub-collector region.
Embodiment 17: The structure of embodiment 16, wherein the base region is an extrinsic base region electrically connecting to an intrinsic base region above the collector region.
Embodiment 18: The structure of embodiment 16 or 17, wherein the sub-collector region comprises N++ dopant.
Embodiment 19: The structure of one of embodiments 16 to 18, wherein the second semiconductor material has a smaller profile than the first semiconductor material.
Embodiment 20: The structure of one of embodiments 13 to 19, further comprising shallow trench isolation structures below the dielectric material, and collector contacts connecting to the first semiconductor material and adjacent to the shallow trench isolation structures and the dielectric material,.
Embodiment 21: A method comprising:
   forming a sub-collector region;
   forming a collector region on or over the sub-collector region, the collector region comprising a first semiconductor material comprising polysilicon material and single crystalline semiconductor material which is over the sub-collector region, and a second semiconductor material on the single crystalline semiconductor material;
   forming diffusion regions in the first semiconductor material;
   forming an emitter region over the collector region; and
   forming a base region adjacent to the emitter region.
Embodiment 22: A method comprising:
   forming a sub-collector region;
   forming a dielectric material above the sub-collector region with an opening exposing the sub-collector region;
   forming a first semiconductor material within the opening and adjacent to the dielectric material, the first semiconductor material comprising polysilicon material adjacent to the dielectric material and single crystalline semiconductor material over the sub-collector region;
   forming a second semiconductor material over the single crystalline semiconductor material;
   forming an emitter region over the second semiconductor material; and
   forming a base region isolated from the emitter region and above the second semiconductor material.
Embodiment 23: The method of embodiment 21 or 22, wherein the structure of one of embodiments 1 to 20 is formed.
   The dependencies of embodiments 15 to 20 as indicated above are not limiting and any of the embodiments 15 to 20 may be directly combined with any of embodiments 1 to 12, instead.
   In the above embodiments, the term "on" may indicate a direct contact such that "A on B" may be understood as "A on and in direct with B", while "over" may be understood as not indicating direct but indirect contact such that "A over B" may be understood as implying "at least one C arranged between A and B". Each of the placeholders A, B, and C may indicate any of layer, element, structure, feature, etc.

## Claims

1. A structure comprising:
a sub-collector region;
a collector region over the sub-collector region, the collector region comprising a first semiconductor material comprising polysilicon material and single crystalline semiconductor material which is over the sub-collector region, and a second semiconductor material on or over the single crystalline semiconductor material;
diffusion regions in the first semiconductor material;
an emitter region over the collector region; and
a base region adjacent to the emitter region.

2. The structure of claim 1, further comprising shallow trench isolation structures isolating the sub-collector region, wherein the structure preferably further comprises collector contacts over the polysilicon material and adjacent to the shallow trench isolation structures.

3. The structure of claim 2, wherein the polysilicon material is over the shallow trench isolation structures and collector contacts extend to the polysilicon material over the shallow trench isolation structures.

4. The structure of claim 3, wherein the diffusion regions are over the shallow trench isolation structures in the polysilicon material and under the collector contacts.

5. The structure of claim 3 or 4, further comprising a dielectric material between the shallow trench isolation structures and the polysilicon material.

6. The structure of claim 5, wherein the dielectric material comprises oxide with an opening to expose the sub-collector region, and/or
wherein the dielectric material comprises a gate dielectric material that is adjacent to the single crystalline semiconductor material sitting over the sub-collector region.

7. The structure of one of claims 1 to 6, wherein the sub-collector region comprises N++ dopant, wherein the N++ dopant preferably comprises a concentration of about or greater than 1e18 cm-3.

8. The structure of one of claims 1 to 7, wherein the second semiconductor material of the collector region comprises single crystalline Si, and/or
wherein the sub-collector region, the collector region, the emitter region and the base region are vertically stacked.

9. The structure of one of claims 1 to 8, further comprising:
a dielectric material above the sub-collector region with an opening exposing the sub-collector region;
the first semiconductor material within the opening and adjacent to the dielectric material, the first semiconductor material comprising polysilicon material adjacent to the dielectric material and single crystalline semiconductor material over the sub-collector region;
the second semiconductor material over the single crystalline semiconductor material;
the emitter region over the second semiconductor material; and
the base region isolated from the emitter region and above the second semiconductor material.

10. The structure of claim 9, further comprising shallow trench isolation structures below the dielectric material, and collector contacts above the shallow trench isolation structures and the dielectric material.

11. The structure of claim 9 or 10, wherein the first semiconductor material and the second semiconductor material comprise a collector region electrically connecting to the sub-collector region.

12. The structure of claim 11, wherein the base region is an extrinsic base region electrically connecting to an intrinsic base region above the collector region, and/or
wherein the second semiconductor material has a smaller profile than the first semiconductor material.

13. The structure of claim 11 or 12, wherein the sub-collector region comprises N++ dopant.

14. The structure of one of claims 9 to 13, further comprising shallow trench isolation structures below the dielectric material, and collector contacts connecting to the first semiconductor material and adjacent to the shallow trench isolation structures and the dielectric material,.

15. A method, comprising:
forming a sub-collector region;
forming a collector region on or over the sub-collector region, the collector region comprising a first semiconductor material comprising polysilicon material and single crystalline semiconductor material which is over the sub-collector region, and a second semiconductor material on the single crystalline semiconductor material;
forming diffusion regions in the first semiconductor material;
forming an emitter region over the collector region; and
forming a base region adjacent to the emitter region.
